(19) **Europäisches Patentamt**

**European Patent Office**

**Office européen des brevets**

(11) **EP 0 721 698 B1**

(12) **EUROPEAN PATENT SPECIFICATION**

(45) Date of publication and mention
of the grant of the patent:
**09.02.2000 Bulletin 2000/06**

(21) Application number: **94927679.4**

(22) Date of filing: **26.09.1994**

(51) Int. Cl.7: **H03L 7/14**, H03L 7/091

(86) International application number:
**PCT/FI94/00432**

(87) International publication number:
**WO 95/09485 (06.04.1995 Gazette 1995/15)**

(54) **METHOD FOR CONTROLLING A PHASE-LOCKED LOOP, AND A PHASE-LOCKED LOOP**

VERFAHREN ZUR STEUERUNG EINES PHASENREGELKREISES UND PHASENREGELKREIS

PROCEDE DE COMMANDE D'UNE BOUCLE A PHASE ASSERVIE, ET BOUCLE A PHASE
ASSERVIE

(84) Designated Contracting States:
**DE FR GB SE**

(30) Priority: **27.09.1993 FI 934231**

(43) Date of publication of application:
**17.07.1996 Bulletin 1996/29**

(73) Proprietor: **Nokia Networks Oy
02150 Espoo (FI)**

(72) Inventor: **KIVIJÄRVI, Antti
FIN-02360 Espoo (FI)**

(74) Representative:
**Äkräs, Tapio Juhani et al
Oy Kolster Ab,
Iso Roobertinkatu 23,
P.O. Box 148
00121 Helsinki (FI)**

(56) References cited:
**EP-A- 0 320 748     US-A- 3 903 482
US-A- 4 531 102**

• **PATENT ABSTRACTS OF JAPAN, Vol. 12, No.
324, E-653; & JP,A,63 090 216 (MATSUSHITA
ELECTRIC IND CO LTD), 21 April 1988 (21.04.88).**

**Description**

The invention relates to a method according to the preamble of attached claim 1 for controlling a phase-locked loop in a locking situation, and to a phase-locked loop according to the preamble of attached claim 6. As used herein, the *locking situation* refers to a situation where the input signal of the loop is disconnected or replaced with another signal, and the loop is thereafter re-locked, either to a new or the old input signal. The solution according to the invention is usable particularly in the generation of synchronizing signals for digital telecommunication systems.

It may become necessary to use synchronizing clocks as independent adjustable oscillators, e.g. when the synchronizing clock has lost its input signal. In telecommunication equipment complying with the SDH standard, for instance, the system clock is forced to remain at the frequency at which it was when it lost its input signal. The clock has to operate independently until it can be re-locked to a synchronizing signal. No significant changes in phase are allowed in the output signal during re-locking; this requirement has also to be met when the input signal is replaced with another signal.

When an analog phase-locked loop is re-locked to the input signal, or the input signal is replaced with another signal, considerable phase changes may occur, particularly if a long chain of frequency dividers precedes the phase detector of the loop. The magnitude of the phase change depends both (a) on the phase difference between the output signal and the input signal of the phase-locked loop at the switching moment and (b) on the properties of the loop filter and the phase detector.

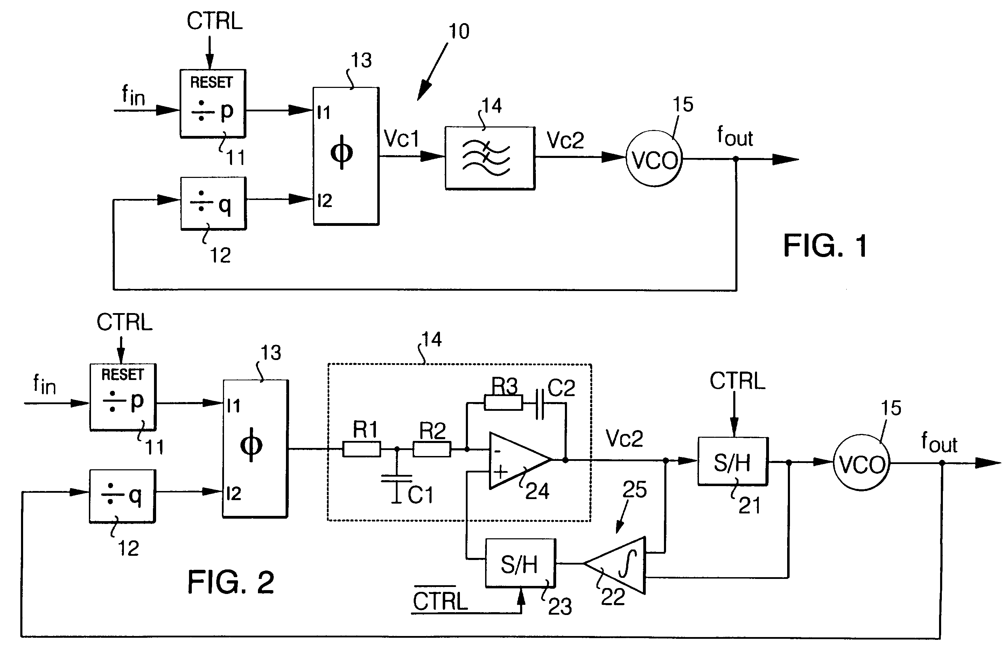

Figure 1 shows a phase-locked loop (PLL) 10 known *per se* in its general configuration, comprising a phase detector 13, a lowpass-type loop filter 14 having an input to which the output signal of the phase detector is connected, and a voltage-controlled oscillator 15 arranged to be controlled by the loop filter. A signal is applied to both inputs, I1 and I2, of the phase detector through a frequency divider 11 and 12, respectively. A signal fin is applied as an input signal to the frequency divider 11, which divides the frequency of the signal fin by the integer p so that a signal having a frequency fin/p (in this test, reference f refers both to the signal and to its frequency) is applied to the first input I1 of the phase detector 13. The output signal fout of the oscillator 15 is applied through the frequency divider 12 back to the second input I2 of the phase detector 13. The phase detector thus compares the phase of the signal having the frequency fin/p with the phase of the signal having the frequency fout/q and generates a control signal Vc1 proportional to their phase difference. This control signal is lowpass-filtered in the loop filter 14, and the filtered signal Vc2 is applied to the oscillator 15 to control it. When the loop is locked, Formula (1) is valid for the output signal of the loop:

$$fout = \frac{q}{p} \, fin \qquad (1)$$

that is, the frequency of the output signal is the frequency of the input signal multiplied with the number q/p.

In the phase-locked loop, the phase of the input signal fin can be adjusted suitably before switching so that the phase shift of the input signals of the phase detector will correspond to the phase shift of the locked state, provided that the loop filter has a sufficiently high DC voltage gain, so that the phase difference remains unchanged despite small frequency changes. In the case shown in Figure 1, for instance, where the input signal is followed by a divider chain 11, the phase adjustment can be performed with the accuracy of one clock period of the input signal by initializing the divider 11 (by resetting its counter) and enabling it appropriately so that a desired phase shift will be obtained between the input signals. For instance, if the frequency of the input signal is 2 MHz, the phase can be set with the accuracy of 500 ns. If this accuracy is not adequate, it is possible, for instance, to increase the frequency of the input signal by a separate multiplier and correct the value of the divisor p correspondingly.

In spite of the phase adjustment of the input signal, there may still occur large instantaneous phase changes in the output of the phase-locked loop. This is because the loop filter may have drifted to the limit of its operating range due to the lack of feedback. (Feedback disappears when the input signal is missing). In a locking situation, it thus takes some time before the filter is again in the normal state.

Even though the phase detector provides zero output when the input signal is missing, even an extremely low offset voltage drives the loop filter to the limit of its operating range if the loop filter has a high DC voltage gain. (The offset voltage is the deviation of the control voltage applied to the loop filter from a value which would maintain the output voltage of the loop filter at a value corresponding to the nominal frequency.) In practice, even thermal drift alone may prevent direct calibration of the offset voltage with a sufficient accuracy.

It is further to be mentioned that the requirements set e.g. in the CCITT recommendation G.81s for the system clock of a SDH network node cannot be met by means of an analog phase-locked loop without a more accurate phasing mechanism.

Phase errors can be prevented by means of a solution in which the actual phase-locked loop is followed by another (wide-bandwidth) phase-locked loop, the output frequency of which is frozen when the input signal is disconnected. During re-locking, the actual phase-locked loop is first allowed to lock and only after this the other phase-locked loop is connected to track the actual phase-locked loop. A drawback of this solution is that the entire system is not locked until the actual phase-locked loop has locked, which may take a very long time.

Another solution is to increase the bandwidth of the loop filter in a locking situation, which as such will not prevent phase errors but merely speeds up the locking.

JP-A-6390216 discloses a PLL comprising a circuit which holds the loop filter output at a constant value when the input signal becomes inadequate for locking. However, said '216 document does not address the problem relating to an output phase jump when locking to the input signal. Such phase jumps are caused by a possible offset in the phase detector output, and they may occur at initial startup of after an extended period of inadequate input signal, during which the phase detector output offset may drift e.g. due to temperature changes.

The object of the present invention is to avoid the above-described problems and to provide a solution, which allows the phase-locked loop to continue from the same phase as accurately as possible on re-locking. This is achieved by means of a method and a phase-locked loop according to the invention, of which the method is characterized by what is described in the characterizing portion of attached claim 1, and the phase-locked loop is characterized by what is described in the characterizing portion of attached claim 6.

The idea of the invention is to maintain the loop filter as accurately as possible in the state where it was when the loop was locked to the input signal, when the input signal is disconnected or becomes inadequate in quality, that is, to prevent the loop filter from "drifting to the limit", from which the restoration to the normal state takes a certain time. In other words, in the invention, the above-mentioned offset voltage is reset in a state in which the phase lock is not locked.

The solution according to the invention prevents any sudden phase changes during the re-locking of the loop, and it allows the output signal to be immediately at its final phase, the accuracy of which depends only on the accuracy of the phase adjustment of the input signal. If the new locking frequency deviates from the old one, a properly designed loop drifts directly towards the new frequency without any sudden phase changes.

In the following the invention and its preferred embodiments will be described by way of example with reference to Figures 2 to 5 in the attached drawings, in which

Figure 1 shows a phase-locked loop known *per se* in its general configuration;
Figure 2 shows a first embodiment of the phase-locked loop according to the invention;
Figure 3 shows an alternative embodiment for the embodiment shown in Figure 2;
Figure 4 shows another alternative embodiment for the embodiment shown in Figure 2; and

Figure 5 shows an additional embodiment for the solutions shown in Figures 2, 3 and 4.

In the solution according to the present invention, the input signal is phased as described above (if the inputs of the phase detector comprise frequency dividers), in addition to which the loop filter is prevented from drifting to the limit of its operating range. As the output of the loop filter is maintained unchanged when the input signal is disconnected, the following locking takes place directly without any sudden phase changes.

Figure 2 shows the first embodiment of the phase-locked loop according to the invention. The same reference numerals as in Figure 1 are used for corresponding parts. In this specific case, the loop filter, shown in greater detail in Figure 2 than in Figure 1, comprises an inverting filter 14 having an operational amplifier 24, resistors R1 to R3, and capacitances C1 and C2, of which the last-mentioned establishes (in series) with the resistor R3 a feedback loop for the operational amplifier. The more detailed implementation of the loop filter may vary in many ways within the scope of solutions known *per se*. The only requirement set for the filter is that it should be active, having an adequate DC voltage gain, in order that small frequency changes would not cause any significant phase changes.

A sampling circuit 21 is positioned between the loop filter 14 and the oscillator 15. It samples the output signal of the loop filter at a predetermined sampling frequency dependent on the application used; stores sample values in a memory over a predetermined time period; and connects an analog control voltage to the oscillator. It is advisable that the sampling circuit is infinite in type, i.e. it should in principle be able to maintain the value of its output signal endlessly. The sampling circuit is implemented in a manner known *per se* by means of A/D and D/A converters and registers.

According to the invention, a second feedback is established from the output of the loop filter to the input of the loop filter or the phase detector. The purpose of this second feedback is to replace the actual feedback loop of the phase-locked loop formed by the oscillator and the phase detector when the input signal is disconnected. By means of the replacing feedback loop the output of the filter is maintained unchanged in spite of the disconnection of the input signal. The following requirements are set for the replacing feedback loop:

- The DC voltage gain has to be high in order that the output of the loop filter would remain unchanged (equal to the frozen control voltage of the oscillator) as accurately as possible.
- The circuit has to be stable even when the feedback loop is replacing the actual loop formed by the oscillator and the phase detector. The replacing feedback loop thus has to be integrating, like the actual loop (the voltage-controlled oscillator).

- It has to be possible to "freeze" the control supplied by the feedback loop (to the input of the filter or the phase detector, as will be described below) when the phase-locked loop is again locked to an input signal of adequate quality. Otherwise a change in this control would appear as an undesired phase change in the output of the phase-locked loop.

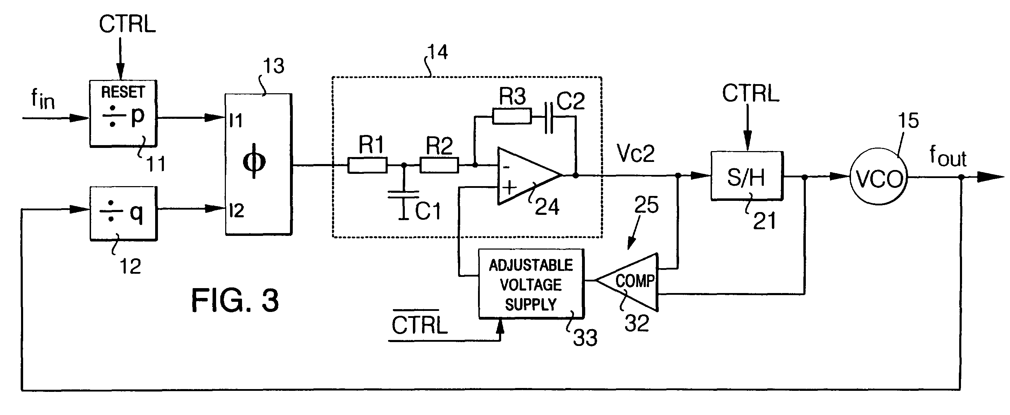

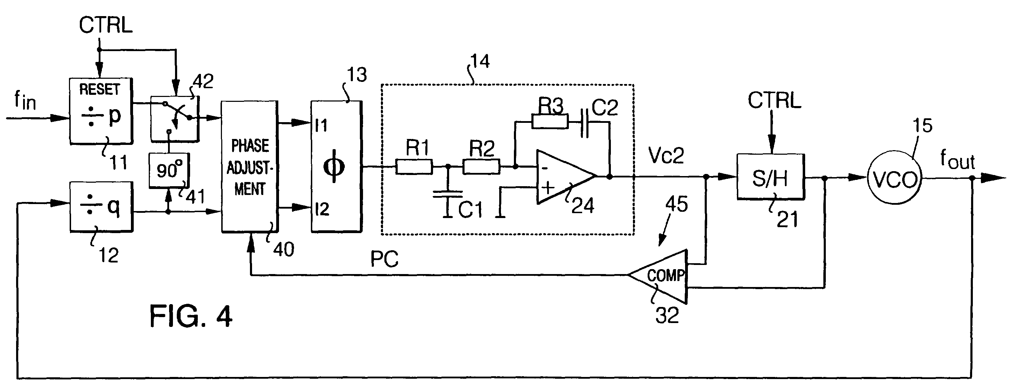

The replacing feedback loop according to the invention has a wide range of different implementations, which will be described below with reference to Figures 2 to 4 (in other respects, the embodiments of Figures 3 and 4 correspond to the solution shown in Figure 2).

In the first embodiment shown in Figure 2, the replacing feedback loop 25 is established through an integrating amplifier 22 and a second sampling circuit 23 to the input of the loop filter. The output of the loop filter 14 is connected to the first input of the amplifier 22, and the output of the first sampling circuit 21 (which output is also connected to control the oscillator) to the second amplifier input. The output of the amplifier is connected to the second sampling circuit 23, the output of which is connected to a non-inverting input of the operational amplifier 24 of the loop filter. When the input signal (fin) is disconnected, the amplifier 22 controls the loop filter through the sampling circuit 23 so that the filter output remains unchanged, that is, equal to the frozen control voltage of the oscillator. Upon relocking to an input signal of adequate quality, the control supplied by the replacing feedback loop to the loop filter is in turn frozen to its current value by means of the sampling circuit 23. The sampling circuit 23 has to be "permanent" in type, i.e. of the same kind as the first sampling circuit 21 (controlling the oscillator) described above.

Figure 3 shows another alternative for the replacing feedback loop 25. In this embodiment, the integrating amplifier and the second sampling circuit are replaced with a comparator 32 and an adjustable voltage supply 33, the value of the output voltage of which the comparator 32 is able to control so as to increase or decrease it. The comparator compares the output signal of the loop filter with the frozen control voltage of the oscillator and controls the voltage supply 33 so that the output signal of the loop filter remains unchanged. The adjusting rate of the voltage supply is selected so that the loop formed by the filter and the replacing feedback remains stable. The adjustable voltage supply 33 can be realized e.g. by an up/down counter and a D/A converter, or alternatively by a circuit which increases or decreases its pulse ratio under the control of the comparator and a lowpass filter following the circuit.

When the phase-locked loop shown in Figure 3 is re-locked to an input signal of adequate quality, the output voltage of the D/A converter or the pulse ratio adjustment, respectively, is "frozen" to the value which it had at the moment of change.

The above-described feedback circuits control the input of the loop filter. The feedback circuit may also control the phase of signals before the phase detector. Figure 4 illustrates this embodiment, where a phase adjustment unit 40 is provided between the frequency dividers and the phase detector. In this case, the replacing feedback loop is indicated with reference numeral 45. Phase adjustment requires that there should be a signal at both inputs of the phase detector, but as the output of the divider 11 is reset when the input signal is missing, this has to be replaced with a signal having the same frequency and phase as when the phase-locked loop is locked in the stable state (the phase difference between the signals is equal to the nominal phase shift of the phase detector in the stable state). The replacing signal can be produced easily by means of the divider 12, e.g. simply by adding a phase shift to its output signal in a phase shift means 41 and connecting a replacing signal by means of a switch 42 in place of the output signal of the divider 11. (In the example shown in Figure 4, the nominal phase shift of the phase detector is 90 degrees.) The mutual phase of the signals is adjusted (by adjusting the delay of one of the signals in the adjustment unit 40) before the phase detector under the control of a phase control signal PC supplied by the comparator 32 so that the output signal of the loop filter remains unchanged.

When the circuit of this embodiment again receives an input signal of adequate quality, to which it is locked, the output of the divider 11 is released to operate normally and the adjusted phase difference is "frozen" to its current value.

The operation of the phase-locked loop according to the invention will be described below in greater detail by using the embodiment shown in Figure 2 as an example. In the other embodiments shown, corresponding feedback means operate similarly.

In the normal state the output signal fout of the loop is locked to the input signal fin, whereby there is a certain constant phase difference between the input signals of the phase detector. The first sampling circuit 21 takes samples into the memory and its output signal forms the control voltage of the oscillator. In this situation the first sampling circuit 21 is thus transparent, i.e. it connects the output signal of the loop filter 14 substantially as such to the oscillator 15.

In the normal state, the value of the output signal of the second sampling circuit 23 has been frozen to a constant value, i.e. the feedback loop 25 does not actually exist, but the phase-locked loop operates in a manner known *per se* by means of its actual feedback path.

When the input signal is disconnected, or when it is replaced with another signal, the counter of the divider 11 is reset (so that the divider will not allow a signal to pass through it). When the input signal is disconnected (or replaced), the output signal of the first sampling circuit (the control of the oscillator) is also frozen immediately to a certain constant value. This constant value, which is determined in the first sampling circuit 21, is preferably a time average calculated for the control signal Vc2 (the output signal of the filter) over a longer period of time. The value that occurred immediately before the input signal was disconnected or replaced is likely to be incorrect, so that it is advisable to calculate the time average as described above instead of using this value.

An indication that the input signal has been disconnected or become inadequate in quality (or that the input signal has been restored or become adequate in quality) is provided in a manner known *per se*, e.g. on the basis of the state and alarm data of the telecommunication system.

At the same time as the input signal is disconnected, or replaced with another signal, the above-mentioned separate feedback loop 25 replacing the actual, disconnected loop is established for the loop filter 14. The feedback loop 25 maintains the outputs of the loop filter and the first sampling circuit equal by adjusting the DC control voltage of the filter. In the stable state, the DC control voltage of the filter is the same as what it was in the normal locked state. In this unlocked state, the sampling circuit 23 of the feedback loop is transparent, i.e. it connects the output signal of the feedback amplifier 22 substantially as such to the loop filter.

When an indication is again received that the input signal is adequate, the counter of the frequency divider 11 is enabled in an appropriate phase so that the phase shift of the input signals of the phase detector corresponds to the phase shift of the locked state. At the same time the output signal of the second sampling circuit 23 is frozen to its current value (which disconnects the feedback loop 25) and the first sampling circuit is released to operate normally so that the output signal of the filter appears again at its output. In Figure 2, the control signal freezing the first sampling circuit is indicated with reference CTRL. Signal $\overline{CTRL}$ controlling the second sampling circuit 23 is the complementary signal of the control signal CTRL, as the second sampling circuit is released when the first sampling circuit is frozen, and *vice versa*.

When the phase-locked loop is started for the first time, the procedure is initially the same as with a missing input signal. A constant value, which is a guess as good as possible at the control voltage required by the locking state, is written in advance into the sampling circuit 21 controlling the oscillator. The feedback amplifier 22 presets the filter into a state as close to the right one as possible and at the same time the output signal of the sampling circuit 23 following the DC control voltage is automatically set to the right value. Only after this the loop is allowed to lock.

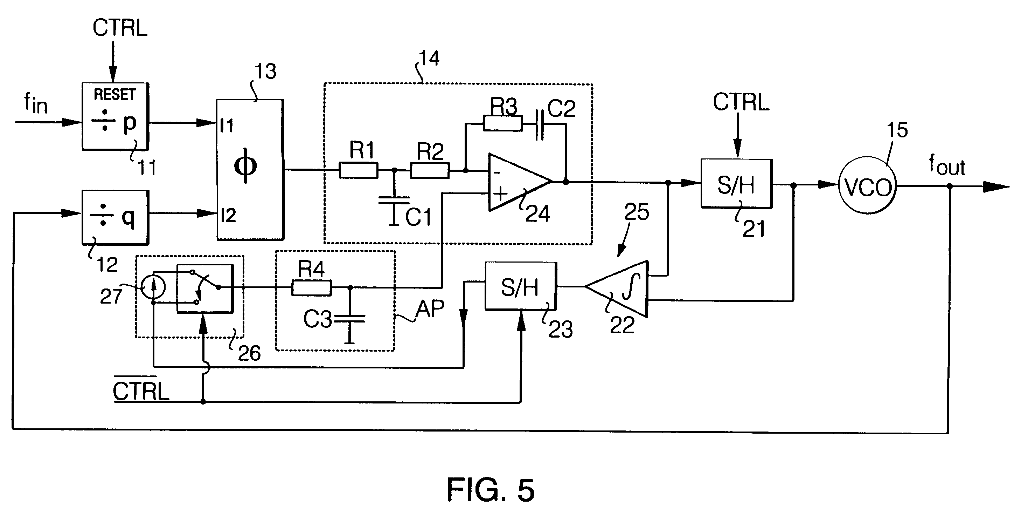

If the output signal of the divider 11 or 12 is asymmetrical with respect to its pulse ratio, the phasing will not operate accurately as such, as the asymmetry causes an offset voltage jump to occur at the output of the phase detector when the input signal is connected to the phase detector (the divider 11 is released). The asymmetrical output signal of the dividers 11 and 12 can, however, be compensated for by simultaneously adding an offset voltage of the same magnitude to the input of the loop filter. This alternative is shown in Figure 5 by using the embodiment shown in Figure 2 as a starting point. A lowpass filter AP similar to the prefilter formed by the resistor R1 and the capacitor C1 is formed between the output of the sampling circuit 23 and the loop filter 14 by means of a resistor R4 and a capacitor C3 in order that the compensating offset voltage would be connected to the loop filter through a similar time constant as the voltage jump from the phase detector. The output signal of the sampling circuit 23 is connected by means of a separate switch 26 through a lowpass filter to the loop filter. When the phase-locked loop is locked, the switch is displaced into the position shown in Figure 5 so that a low offset voltage (typically a few mV in magnitude) formed by the offset voltage supply 27 is added to the filter input. When the phase-locked loop is unlocked, the switch 26 is in the opposite position, so that the output voltage of the sampling circuit will be switched directly to the lowpass filter (without the addition of the offset voltage). The switch 26 is controlled by the same control signal as the sampling circuit 23. In other respects, the preferred embodiment shown in Figure 5 corresponds to the first embodiment shown in Figure 2, but the solution may equally well be applied to the embodiments shown in Figures 3 and 4.

Still another advantage of the solution according to the invention is that an indication that the filter has settled (which, in practice, is highly significant, particularly if the time constant of the loop filter is high) is obtained easily e.g. by monitoring the output signal of the feedback amplifier or the comparator.

Even though the invention has been described above with reference to the examples of the attached drawings, it is self-evident that the invention is not related to it, but it can be modified within the inventive idea defined above and in the attached claims. For instance, the loop need not necessarily have the frequency dividers (11 or 12) preceding the phase detector (in such a case, however, the circuit has to include a latch circuit disabling the signal of inadequate quality before the phase detector). If there is no frequency divider 11 dividing the frequency of the input signal, the above-mentioned resetting and enabling of the counter are also omitted; in other respects the circuit operates as described above. If the divider 11 or 12 is omitted, it, however, has to be attended to that the input signals are symmetrical in pulse ratio or alternatively, the compensation described above has to be performed.

**Claims**

1. Method for controlling a phase-locked loop in a locking situation, the loop comprising a phase detector (13), a loop filter (14) and a voltage-controlled oscillator (15) connected in succession, a feedback path being established from the output of the oscillator to a second input (I2) in the phase detector, and an input signal to which the loop is locked being applied to a first input (I1) in the phase detector (13), and

in response to a change causing a currently used input signal to become inadequate for locking, the signal connected from the loop filter (14) to the oscillator (15) is frozen to a constant value and an additional feedback loop is connected to maintain the output signal of the loop filter substantially at said constant value, and

in response to a change causing the signal to become again adequate for locking, said freezing is removed, **characterized** in that

when said additional feedback is connected in response to a change causing the currently used input signal to become inadequate for locking, the input of the loop filter is maintained connected to the phase detector and said inadequate signal is disabled before the phase detector; and

the control provided by said additional feedback loop is frozen substantially at its current value in response to a change causing the signal to become again adequate for locking.

2. Method according to claim 1, **characterized** in that said additional feedback loop is established from the output of the loop filter to its input.

3. Method according to claim 1, **characterized** in that the mutual phase of signals applied to the phase detector (13) is adjusted by means of said additional feedback loop.

4. Method according to claim 1, **characterized** in that a time average of the output signal (Vc2) of the filter (14) calculated over a time period of a predetermined length is used as said constant value.

5. Method according to claim 1, **characterized** in that when the phase-locked loop comprises a frequency divider (11) through which the input signal is applied to the phase detector (13),

the counter of the frequency divider is reset in response to a change causing a currently used input signal to become inadequate for locking, and

in response to a change causing a currently used input signal to become adequate for locking, the counter of the frequency divider is enabled so that the phase difference between the input signals of the phase detector immediately corresponds to the nominal phase shift of the phase detector.

6. Phase-locked loop comprising

a phase detector (13), a loop filter (14) and a voltage-controlled oscillator (15) connected in succession, a feedback path being established from the output of the oscillator to a second input (I2) in the phase detector, and a first input of said phase detector forming an input for an input signal to which the loop is locked, means (21) for freezing a signal connected from the loop filter (14) to the oscillator (15) to a constant value, and feedback means (25, 45) fed back from the output of the loop filter so that an additional feedback path can be established for the phase-locked loop, the additional feedback path being operationally connected to maintain the output signal of the loop filter (14) substantially at said constant value, **characterized** in that the connection between the phase detector and the loop filter is maintained when said additional feedback path is operative, and

the phase-locked loop further comprises means (11) for disabling said input signal before said phase detector and means for freezing the control provided by said feedback loop of the loop filter (14) substantially at its current value in response to a change causing the signal to become again adequate for locking.

7. Phase-locked loop according to claim 6, **characterized** in that said means for freezing the signal connected to the oscillator (15) to a constant value comprise a sampling circuit (21) including means for calculating the constant value on the basis of sample values.

8. Phase-locked loop according to claim 7, **characterized** in that said feedback means for maintaining the loop filter at said constant value comprise a feedback amplifier (22) having a first input connected to the output of the loop filter, a second input connected to the output of said sampling circuit (21), and an output which is operationally connected to provide DC control voltage for the loop filter.

9. Phase-locked loop according to claim 8, **characterized** in that said feedback means for maintaining the loop filter at said constant value further comprise a sampling circuit (23) arranged between the feedback amplifier (22) and the filter (14), the value of the output signal of the sampling circuit being

10. Phase-locked loop according to claim 7, **characterized** in that said feedback means for maintaining the loop filter at said constant value comprise a comparator (32) having a first input connected to the output of the loop filter (14) and a second input connected to the output of said sampling circuit (21), and an adjustable voltage supply (33), the output signal of the comparator being connected to control the voltage supply, whereby the output of the voltage supply provides DC control voltage for the loop filter (14).

11. Phase-locked loop according to claim 10, **characterized** in that the adjustable voltage supply (33) comprises means for generating a signal having an adjustable pulse ratio, and means for lowpass-filtering said signal.

12. Phase-locked loop according to claim 10, **characterized** in that the adjustable voltage supply (33) comprises an up/down counter and a D/A converter, which is controlled by the counter.

13. Phase-locked loop according to claim 7, **characterized** in that said feedback means for maintaining the loop filter at said constant value comprise a comparator (32) having a first input connected to the output of the loop filter (14) and a second input connected to the output of said sampling circuit (21), and the output of which is connected to phase-adjusting means (40) provided at the input of the phase detector (13) for adjusting the mutual phase of signals fed to the phase detector.

14. Phase-locked loop according to claim 6, **characterized** in that it further comprises means (26, 27) for adding a low offset voltage to the input of the loop filter.

**Patentansprüche**

1. Verfahren zur Steuerung eines Phasenregelkreises in einer Verriegelungssituation, wobei der Regelkreis eine Phasenerfassungseinrichtung (13), ein Regelkreisfilter (14) und einen spannungsgesteuerten Oszillator (15) aufweist, die in Reihe geschaltet sind, wobei ein Rückkopplungszweig von dem Ausgang des Oszillators zu einem zweiten Eingang (I2) der Phasenerfassungseinrichtung eingerichtet ist, und wobei ein Eingangssignal, für das der Regelkreis verriegelt ist, an einem ersten Eingang (I1) der Phasenerfassungseinrichtung (13) angelegt ist, und wobei

im Ansprechen auf eine Änderung, die bedingt, daß ein derzeit verwendetes Eingangssignal zur Verriegelung ungeeignet wird, das von dem Regelkreisfilter (14) zu dem Oszillator (15) geführte Signal auf einen konstanten Wert eingefroren wird und eine zusätzliche Rückkopplungsschleife angeschlossen wird, um das Ausgangssignal des Regelkreisfilters im wesentlichen auf dem konstanten Wert beizubehalten, und

im Ansprechen auf eine Änderung, die bedingt, daß das Signal wieder zur Verriegelung geeignet wird, das Einfrieren beseitigt wird,

**dadurch gekennzeichnet, daß**

wenn die zusätzliche Rückkopplung im Ansprechen auf eine Änderung, die bedingt, daß das derzeit verwendete Eingangssignal zur Verriegelung ungeeignet wird, angeschlossen wird, der Eingang des Regelkreisfilters an die Phasenerfassungseinrichtung angeschlossen bleibt und das ungeeignete Signal vor der Phasenerfassungseinrichtung unwirksam gemacht wird; und

die durch die zusätzliche Rückkopplungsschleife bereitgestellte Regelung im Ansprechen auf eine Änderung, die bedingt, daß das Signal wieder zur Verriegelung geeignet wird, im wesentlichen auf ihrem derzeitigen Wert eingefroren wird.

2. Verfahren nach Anspruch 1, **dadurch gekennzeichnet, daß** die zusätzliche Rückkopplungsschleife von dem Ausgang des Regelkreisfilters zu dessen Eingang eingerichtet wird.

3. Verfahren nach Anspruch 1, **dadurch gekennzeichnet, daß** die Phasenbeziehung zwischen an die Phasenerfassungseinrichtung (13) angelegten Signalen mittels der zusätzlichen Rückkopplungsschleife eingeregelt wird.

4. Verfahren nach Anspruch 1, **dadurch gekennzeichnet, daß** ein zeitlicher Mittelwert des Ausgangssignals (Vc2) des Filters (14), der für eine Zeitdauer einer vorbestimmten Länge berechnet wird, als der konstante Wert verwendet wird.

5. Verfahren nach Anspruch 1, **dadurch gekennzeichnet, daß**

wenn der Phasenregelkreis einen Frequenzteiler (11) aufweist, durch den das Eingangssignal an die Phasenerfassungseinrichtung (13) angelegt wird, der Zähler des Frequenzteilers im Ansprechen auf eine Änderung, die bedingt, daß ein derzeit verwendetes Eingangssignal zur Verriegelung ungeeignet wird, rückgesetzt wird, und im Ansprechen auf eine Änderung, die bedingt, daß ein derzeit verwendetes Eingangssignal zur Verriegelung geeignet wird, der Zähler des Frequenzteilers freigegeben wird, so daß die Phasendifferenz zwischen den Eingangssignalen der Phasenerfassungseinrichtung unmittelbar der Nenn-Phasenverschiebung der Phasenerfassungseinrichtung entspricht.

6. Phasenregelkreis, mit

   einer Phasenerfassungseinrichtung (13), einem Regelkreisfilter (14), und einem spannungsgesteuerten Oszillator (15), die in Reihe geschaltet sind, wobei ein Rückkopplungszweig von dem Ausgang des Oszillators zu einem zweiten Eingang (I2) der Phasenerfassungseinrichtung eingerichtet ist, und ein erster Eingang der Phasenerfassungseinrichtung einen Eingang für ein Eingangssignal bildet, für das der Regelkreis verriegelt ist,
   einer Einrichtung (21) zum Einfrieren eines von dem Regelkreisfilter (14) zu dem Oszillator (15) geführten Signals auf einen konstanten Wert, und
   einer von dem Ausgang des Regelkreisfilters derart zurückgeführten Rückkopplungseinrichtung (25, 45), daß ein zusätzlicher Rückkopplungszweig für den Phasenregelkreis eingerichtet werden kann, wobei der zusätzliche Rückkopplungszweig funktionell angeschlossen ist, um das Ausgangssignal des Regelkreisfilters (14) im wesentlichen auf dem konstanten Wert zu halten,
   **dadurch gekennzeichnet, daß**
   die Verbindung zwischen der Phasenerfassungseinrichtung und dem Regelkreisfilter beibehalten wird, wenn der zusätzliche Rückkopplungszweig in Betrieb ist, und
   der Phasenregelkreis zudem eine Einrichtung (11) aufweist, um das Eingangssignal vor der Phasenerfassungseinrichtung unwirksam zu machen, und eine Einrichtung aufweist, um im Ansprechen auf eine Änderung, die bedingt, daß das Signal wieder zur Verriegelung geeignet wird, die durch die Rückkopplungsschleife des Regelkreisfilters (14) bereitgestellte Regelung im wesentlichen auf deren derzeitigem Wert einzufrieren.

7. Phasenregelkreis nach Anspruch 6, **dadurch gekennzeichnet, daß** die Einrichtung zum Einfrieren des an den Oszillator (15) angeschlossenen Signals auf einen konstanten Wert eine Abtastschaltung (21) aufweist, die eine Einrichtung zur Berechnung des konstanten Werts auf der Grundlage von Abtastwerten enthält.

8. Phasenregelkreis nach Anspruch 7, **dadurch gekennzeichnet, daß** die Rückkopplungseinrichtung zum Beibehalten des Regelkreisfilters auf dem konstanten Wert einen rückgekoppelten Verstärker (22) aufweist, der einen an den Ausgang des Regelkreisfilters angeschlossenen ersten Eingang, einen an den Ausgang des Abtastschaltung (21) angeschlossenen zweiten Eingang und einen Ausgang hat, welcher funktionell angeschlossen ist, um eine Gleichspannungssteuerspannung für das Regelkreisfilter bereitzustellen.

9. Phasenregelkreis nach Anspruch 8, **dadurch gekennzeichnet, daß** die Rückkopplungseinrichtung zum Beibehalten des Regelkreisfilters auf dem konstanten Wert zudem eine Abtastschaltung (23) aufweist, die zwischen dem rückgekoppelten Verstärker (22) und dem Filter (14) angeordnet ist, wobei der Wert des Ausgangssignals der Abtastschaltung auf einen konstanten Wert eingefroren werden kann.

10. Phasenregelkreis nach Anspruch 7, **dadurch gekennzeichnet, daß** die Rückkopplungseinrichtung zum Beibehalten des Regelkreisfilters auf dem konstanten Wert einen Vergleicher (32) aufweist, der einen an den Ausgang des Regelkreisfilters (14) angeschlossenen ersten Eingang und einen an den Ausgang des Abtastschaltung (21) angeschlossenen zweiten Eingang hat, und eine einstellbare Spannungsquelle (33) aufweist, wobei das Ausgangssignal des Vergleichers zur Steuerung der Spannungsquelle angeschlossen ist, wodurch der Ausgang der Spannungsquelle eine Gleichspannungssteuerspannung für das Regelkreisfilter (14) bereitstellt.

11. Phasenregelkreis nach Anspruch 10, **dadurch gekennzeichnet, daß** die einstellbare Spannungsquelle (33) Einrichtungen zur Erzeugung eines Signals mit einem einstellbaren Impulsverhältnis und Einrichtungen zur Tiefpassfilterung des Signals aufweist.

12. Phasenregelkreis nach Anspruch 10, **dadurch gekennzeichnet, daß** die einstellbare Spannungsquelle (33) einen Aufwärts- / Abwärtszähler und einen durch den Zähler gesteuerten D/A Wandler aufweist.

13. Phasenregelkreis nach Anspruch 7, **dadurch gekennzeichnet, daß** die Rückkopplungseinrichtung zum Beibehalten des Regelkreisfilters auf dem konstanten Wert einen Vergleicher (32) aufweist, der einen an den Ausgang des Regelkreisfilters (14) angeschlossenen ersten Eingang und einen an den Ausgang des Abtastschaltung (21) angeschlossenen zweiten Eingang hat, und dessen Ausgang an eine Phaseneinstelleinrichtung (40) angeschlossen ist, die am Eingang der Phasenerfassungseinrichtung (13) zur Einstellung der Phasenbeziehung zwischen der Phasenerfassungseinrichtung zugeführten Signalen bereitgestellt ist.

14. Phasenregelkreis nach Anspruch 6, **dadurch gekennzeichnet, daß** er zudem Einrichtungen (26, 27) zum Addieren einer niedrigen Offset-Spannung zu dem Eingang des Regelkreisfilters aufweist.

**Revendications**

1. Procédé pour commander une boucle à verrouillage de phase dans une situation de verrouillage, la boucle comportant un détecteur (13) de phase, un filtre (14) de boucle et un oscillateur (15) commandé en tension connectés successivement, un circuit de réaction étant établi entre la sortie de l'oscillateur et une seconde entrée (I2) dans le détecteur de phase, et un signal d'entrée par rapport auquel est asservie la boucle étant appliqué à une première entrée (I1) dans le détecteur (13) de phase, et

en réponse à un changement amenant un signal d'entrée utilisé à un moment donné à devenir non adéquat pour un verrouillage, le signal appliqué depuis le filtre (14) de boucle à l'oscillateur (15) est gelé à une valeur constante et une boucle de réaction supplémentaire est connectée pour maintenir le signal de sortie du filtre de boucle sensiblement à ladite valeur constante, et
en réponse à un changement amenant le signal à redevenir adéquat pour un verrouillage, ledit gel est supprimé,
caractérisé en ce que
lorsque ladite boucle de réaction supplémentaire est connectée en réponse à un changement amenant le signal d'entrée utilisé à ce moment à devenir non adéquat pour un verrouillage, l'entrée du filtre de boucle est maintenue connectée au détecteur de phase et ledit signal non adéquat est invalidé avant le détecteur de phase ; et
la commande assurée par ladite boucle de réaction supplémentaire est gelée sensiblement à sa valeur instantanée en réponse à un changement amenant le signal à redevenir adéquat pour un verrouillage.

2. Procédé selon la revendication 1, caractérisé en ce que ladite boucle de réaction supplémentaire est établie entre la sortie du filtre de boucle et son entrée.

3. Procédé selon la revendication 1, caractérisé en ce que la phase mutuelle de signaux appliqués au détecteur (13) de phase est réglée à l'aide de ladite boucle de réaction supplémentaire.

4. Procédé selon la revendication 1, caractérisé en ce qu'une moyenne dans le temps du signal (Vc2) de sortie du filtre (14), calculée sur un laps de temps d'une durée prédéterminée, est utilisée comme dite valeur constante.

5. Procédé selon la revendication 1, caractérisé en ce que, lorsque la bande à verrouillage de phase comporte un circuit (11) diviseur de fréquence par l'intermédiaire duquel le signal d'entrée est appliqué au détecteur (13) de phase,

le compteur du circuit diviseur de fréquence est mis à zéro en réponse à un changement amenant un signal d'entrée utilisé à cet instant à devenir non adéquat pour un asservissement, et
en réponse à un changement amenant un signal d'entrée utilisé à cet instant à devenir adéquat pour un verrouillage, le compteur du circuit diviseur de fréquence est validé de façon que la différence de phase entre les signaux d'entrée du détecteur de phase corresponde immédiatement au déphasage nominal du détecteur de phase.

6. Bande à verrouillage de phase, comprenant

un détecteur (13) de phase, un filtre (14) de boucle et un oscillateur (15) commandé en tension, connectés successivement, un circuit de réaction étant établi entre la sortie de l'oscillateur et une seconde entrée (I2) dans le détecteur de phase, et une première entrée dudit détecteur de phase formant une entrée pour un signal d'entrée par rapport auquel la boucle est verrouillée,
un moyen (21) pour geler à une valeur constante un signal appliqué par le filtre (14) de boucle à l'oscillateur (15), et
des moyens de réaction (25, 45) soumis à une réaction depuis la sortie du filtre de boucle de façon qu'un trajet de réaction supplémentaire puisse être établi pour la bande à verrouillage de phase, le trajet de réaction supplémentaire coopérant pour maintenir sensiblement à ladite valeur constante le signal de sortie du filtre (14) de boucle,
caractérisée en ce que la connexion entre le détecteur de phase et le filtre de boucle est maintenue lorsque ledit trajet de réaction supplémentaire est en fonctionnement, et
la bande à verrouillage de phase comporte en outre un moyen (11) pour invalider ledit signal d'entrée avant ledit détecteur de phase et un moyen pour geler à sa valeur instantanée la commande fournie par ladite boucle de réaction du filtre (14) de boucle en réponse à un changement amenant le signal à redevenir adéquat pour un verrouillage.

7. Bande à verrouillage de phase selon la revendication 6, caractérisée en ce que ledit moyen pour geler à une valeur constante le signal fourni à l'oscillateur (15) comporte un circuit d'échantillonnage (21) comprenant un moyen servant à calculer la valeur constante sur la base de valeurs échantillons.

8. Bande à verrouillage de phase selon la revendication 7, caractérisée en ce que ledit moyen de réaction pour maintenir le filtre de boucle à ladite valeur constante comporte un amplificateur (22) de réaction ayant une première entrée connectée à la sortie du filtre de boucle, une seconde entrée connectée à la sortie dudit circuit d'échantillonnage (21), et une sortie qui coopère pour fournir une tension continue de commande pour le filtre de boucle.

9. Bande à verrouillage de phase selon la revendication 8, caractérisée en ce que ledit moyen de réaction pour maintenir le filtre de boucle à ladite valeur constante comporte en outre un circuit d'échantillonnage (23) disposé entre l'amplificateur (22) de réaction et le filtre (14), la valeur du signal de sortie du circuit d'échantillonnage pouvant être gelée à une valeur constante.

10. Bande à verrouillage de phase selon la revendication 7, caractérisée en ce que ledit moyen de réaction pour maintenir le filtre de boucle à ladite valeur constante comporte un comparateur (32) ayant une première entrée connectée à la sortie du filtre (14) de boucle et une seconde entrée connectée à la sortie dudit circuit d'échantillonnage (21), et une source (33) de tension réglable, le signal de sortie du comparateur étant appliqué pour commander la source de tension, grâce à quoi la sortie de la source de tension fournit une tension continue de commande pour le filtre (14) de boucle.

11. Bande à verrouillage de phase selon la revendication 10, caractérisée en ce que la source (33) de tension réglable comporte un moyen pour générer un signal ayant un rapport cyclique d'impulsions réglable, et un moyen pour soumettre ledit signal à un filtrage passe-bas.

12. Bande à verrouillage de phase selon la revendication 10, caractérisée en ce que la source (33) de tension réglable comporte un compteur-décompteur et un convertisseur N/A, qui est commandé par le compteur.

13. Bande à verrouillage de phase selon la revendication 7, caractérisée en ce que ledit moyen de réaction pour maintenir le filtre de boucle à ladite valeur constante comporte un comparateur (32) ayant une première entrée connectée à la sortie du filtre (14) de boucle et une seconde entrée connectée à la sortie dudit circuit d'échantillonnage (21), et dont la sortie est connectée à un moyen (40) de réglage de phase disposé à l'entrée du détecteur (13) de phase pour régler la phase mutuelle de signaux appliqués au détecteur de phase.

14. Bande à verrouillage de phase selon la revendication 6, caractérisée en ce qu'elle comporte en outre des moyens (26, 27) pour ajouter une tension de décalage basse à l'entrée du filtre de boucle.

FIG. 1

FIG. 2

EP 0 721 698 B1

FIG. 3

EP 0 721 698 B1

FIG. 4

EP 0 721 698 B1

FIG. 5